# EUROPEAN PATENT APPLICATION

(11) **EP 0 691 805 A1**
(43) Date of publication of application: **10.01.1996**
(21) Application number: 95110677.2
(22) Date of filing: 07.07.1995
(51) Int. Cl.: H05K 13/04

(54) **Electronic-part surface mounting apparatus**

(30) Priority: 08.07.1994 JP 179656/94
(71) Applicant: KABUSHIKI KAISHA SANKYO SEIKI SEISAKUSHO, Suwa-gun Nagano 393 (JP)
(72) Inventor: Yazawa, Takayuki, c/o K.K. Sankyo, Ina-shi, Nagano (JP); Komase, Hiroshi, c/o K.K. Sankyo, Ina-shi, Nagano (JP); Shizawa, Hiroyuki, c/o K.K. Sankyo, Ina-shi, Nagano (JP)
(74) Representative: Grünecker, Kinkeldey, Stockmair & Schwanhäusser Anwaltssozietät

(57) **Abstract**

An array of absorption nozzles, mounted on the lower end of a Z-shaft, is rotatable about an axis parallel to a mounted surface in a plane orthogonal to the mounted surface. A partial transmission mirror is located between the mounted surface and a camera. A first combination of a first shutter and a first light source is arrayed in a plane parallel to the mounted surface, which is provided for taking an image on the mounted surface. A second combination of a second shutter and a second light source is arrayed in a plane orthogonal to the mounted surface, which is provided for taking an image on the nozzle. In the first and second combinations, to take the image on the absorption nozzle, the second shutter is opened and the second light source lights up the image, and to take the image on the mounted surface, the first shutter is opened and the first light lights up the image. Thus, the position recognition of the two images can be carried out by the one camera. Further, the position recognition and the part mounting can successively be carried out by merely making index-rotation of the array of the absorption nozzles in the plane orthogonal to the mounted surface. Accordingly, when comparing with the apparatus in which a mounted part is moved to a camera fixed at one corner of a stack, the part mounting speed is increased by the time taken for the part to be moved to the camera.

## Description

### BACKGROUND OF THE INVENTION

The present invention relates to an electronic-part surface mounting apparatus.More particularly, the invention relates to an apparatus for recognizing the position of an electronic part to be mounted (hereinafter referred to as a mounted part) and a printed circuit board on which the mounted part is to be mounted.

A position recognition device of a conventional electronic-part surface mounting apparatus includes a first camera for recognizing the position of a printed circuit board and a second camera for recognizing the position of a mounted part. The Z shaftis rotatable and vertically movable while holding an electronic part with absorption means or nozzle mounted on the end of the Z shaft. The first camera is arrayed parallel to the Z shaft. The second camera is mounted on the stack of the mounting apparatus.

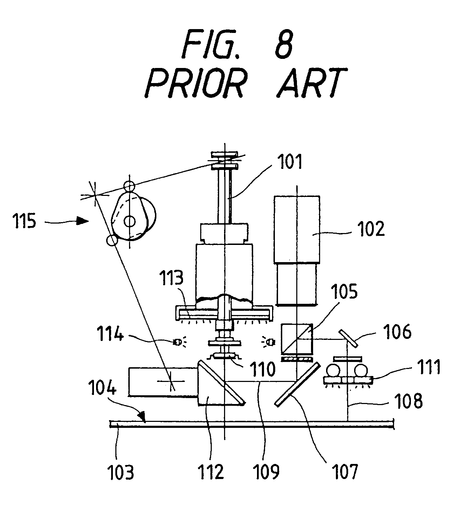

There is another conventional position recognition device in which one camera is used for recognizing the positions of the mounted surface of a printed circuit board and a mounted part. As shown in Fig. 8, in this device, a camera 102 is mounted so that the optical axis thereof is parallel to a Z shaft 101 which is movable in the direction vertical to a mounted surface 104 of a printed circuit board 103 and is rotatable in a plane parallel to the mounted surface 104. A beam splitter 105 is located between the camera 102 and the mounted surface 104. Mirrors 106 and 107 are disposed on the optical paths of the beam splitter 105, respectively. A mark recognition path 108 is provided for recognizing the position of the printed circuit board 103. A part position recognition path 109 is provided for recognizing the position of a mounted part 110. In the mark recognition path 108, a ring-like light source 111 is disposed between the mirror 106 and the mounted surface 104. A light beam is emitted from the light source 111, reflected by the mounted surface 104, passes through the center of the ring-like light source 111, reflected by the mirror 106, passes through the beam splitter 105, and finally enters the camera 102. The part position recognition path 109 is made up of a mirror 107 disposed in the front of the beam splitter 105, a moving mirror 112, and light sources disposed around the Z shaft 101, such as an EL element 113 and a LED 114. The moving mirror 112 is moved, by a cam mechanism 115, in the direction parallel to the mounted surface 104 when the Z shaft 101 moves in the axial direction or in the vertical direction Such a movement of the mirror 112 is made for avoiding the interference thereof with the Z shaft 101.

In the electronic-part surface mounting apparatus which uses the two cameras, the first cameral for the position recognition of the printed circuit board and the second camera for the position recognition of the mounted part, the mounter head must be moved up to the second camera mounted on the mounting apparatus every time it holds an electronic part by absorptive attraction. The part mounting speed is reduced by the time taken for the head to move.

The electronic-part surface mounting apparatus, which uses one camera 102 for the position recognition of both the printed circuit board and the mounted part as shown in Fig. 8, requires the moving mirror 112, the cam mechanism 115 for driving it, and the like. Use of those components results in a complexity of the construction thereof and an additional time consumption for the operation of those components, which leads to a slow part mounting work.

### SUMMARY OF THE INVENTION

Accordingly, an object of the present invention is to provide an electronic-part surface mounting apparatus in which one camera is used for recognizing the positions of both the printed circuit board and the mounted part held by absorptive attraction, the construction thereof is simple and the mounting speed thereof is increased.

To achieve the above object, there is provided an electronic-part surface mounting apparatus having a Z-shaft vertically movable with respect to the mounted surface of a printed circuit board on which an electronic part is to be mounted, and a camera with the optical axis parallel to the Z-shaft, the apparatus comprising: an array of absorption nozzles, mounted on the lower end of the Z-shaft, being rotatable about an axis parallel to the mounted surface in a plane orthogonal to the mounted surface; a partial transmission mirror located between the mounted surface and the camera; a first shutter and a first light source disposed in a plane parallel to the mounted surface, a first image on the mounted surface being taken by the camera by opening the first shutter and lighting the first image by the first light source; and a second shutter and a second light source disposed in a plane orthogonal to the mounted surface, a second image on the absorption nozzle being taken by the camera by opening the second shutter and lighting the second image by the second light source.

The array of the absorption nozzles, which is mounted on the lower end of the Z-shaft, is turned, and the nozzles are successively directed downward. The nozzle directed downward attracts an electronic part from the part supply means, by absorption. The first shutter arrayed parallel to the mounted surface is opened and the first light source is switched on, while at the same time the second shutter arrayed orthogonal to the mounted surface is closed and the second light source is switched off. Under this condition, the position of the printed circuit board is recognized by taking an image on the mounted surface, received through the partial transmission mirror. The position of the electronic part is recognized while the electronic parts are successively picked up from the part supply means while making index-rotation of the array of the absorption nozzles. After all the absorption nozzles attract the electronic parts by absorption, the position of the electronic part last attracted or seized is recognized while the electronic part is moved to the printed circuit board. For this position recognition, the second shutter arrayed orthogonal to the mounted surface is opened and the second light source is switched on, while at the same time the first shutter arrayed parallel to the mounted surface is closed and the first light source is switched off, and an image on the nozzle is taken through the partial transmission mirror.

### BRIEF DESCRIPTION OF THE DRAWINGS

Fig. 1 is a longitudinal sectional view showing an electronic-part surface mounting apparatus according to an embodiment of the present invention,
Fig. 2 is a longitudinal sectional view taken along line II - II in Fig. 1,
Fig. 3 is a view seen in the direction of an arrow denoted as III in Fig. 1, the view showing a second shutter and a second light source,
Fig. 4 is a side view of the construction of Fig. 3,
Fig. 5 is a sectional view, partly broken, seen from the bottom and taken along line V - V in Fig. 1,
Fig. 6 is a sectional view seen in the direction of an arrow denoted as VI in Fig. 2, the view showing a mechanism for making index-rotation of the nozzle array,
Fig. 7 is a timing chart showing the operation when the mounter head pick up an electronic part and mounts it on the printed circuit board, and
Fig. 8 is a view showing a conventional electronic-part surface mounting apparatus.

### DETAILED DESCRIPTION OF THE INVENTION

The preferred embodiment of the present invention will be described in detail with reference to the accompanying drawings.

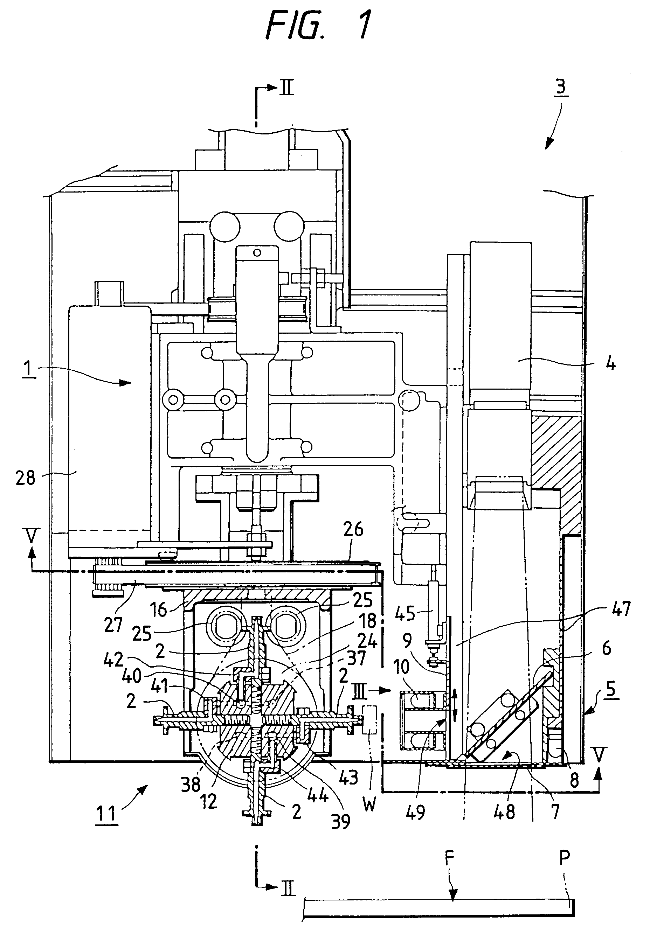

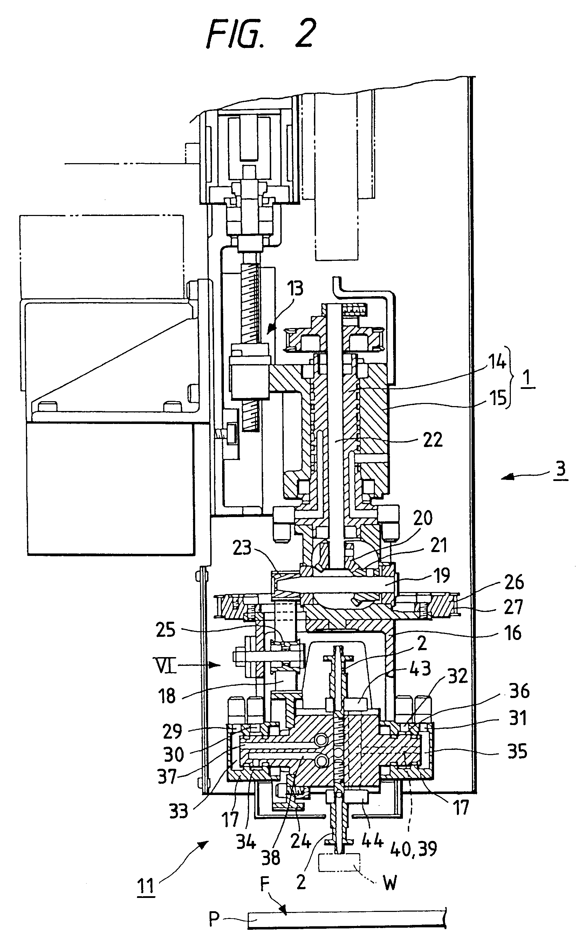

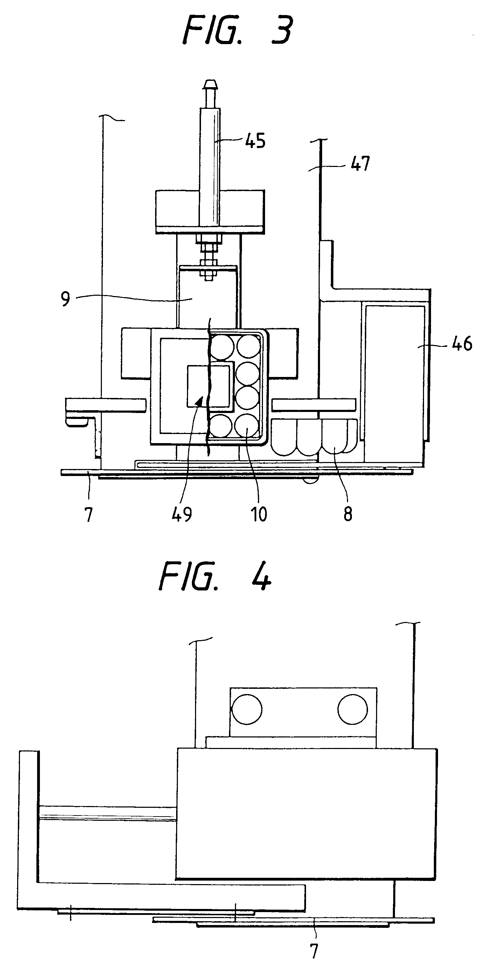

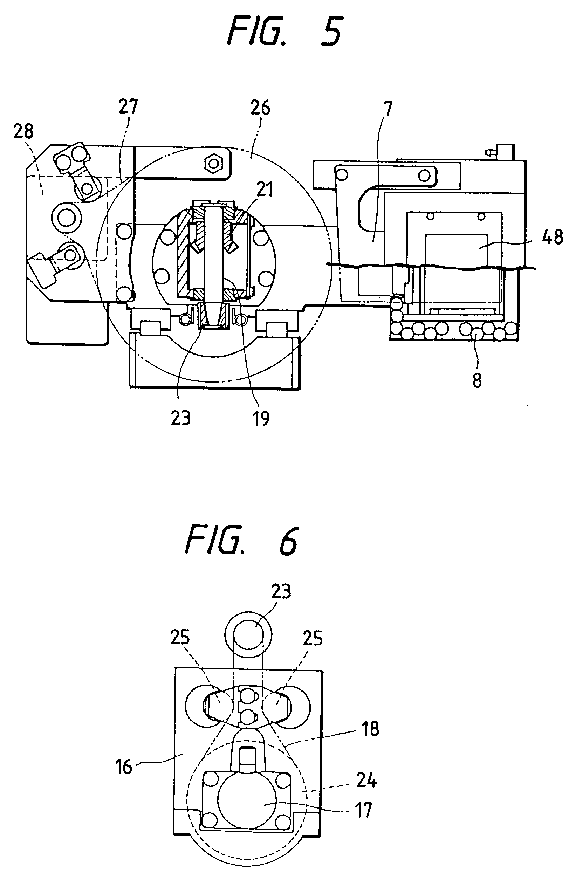

Figs. 1 through 6 show an embodiment of an electronic-part surface mounting apparatus according to the present invention. The electronic-part surface mounting apparatus is made up of a Z-shaft 1, a mounter head 3, a camera 4, and an image pick-up means 5. The Z-shaft 1 is vertically movable with respect to a mounted surface F of a printed circuit board P on which an electronic part W is to be mounted and is rotatable in a plane parallel to the mounted surface F of the printed circuit board P. The mounter head 3 includes a plural number of absorption nozzles 2 attached to the lower end (as viewed in the drawing) of the Z-shaft 1. The nozzles 2 are rotatable for making index-rotation about the axis parallel to the mounted surface F in a plane orthogonal to the mounted surface F. The camera 4 is mounted on the mounter head 3 in a state that the optical axis thereof is arranged in parallel with the Z-shaft 1. The image pick-up means 5 as a part of the optical system of the camera 4 is able to selectively pick up or take an image on the mounted surface F or an image on the nozzle 2.

The image pick-up means 5 includes a partial transmission mirror 6 located between the mounted surface F and the camera 4, a first combination of a first shutter 7 and a first light source 8 which is arrayed in a plane parallel to the mounted surface F, and a second combination of a second shutter 9 and a second light source 10, which are arrayed in a plane orthogonal to the mounted surface F. In operation, the shutter 7 or 9 is opened and its associated light source 8 or 10 is switched on, whereby an image on the mounted surface F or an image on the nozzle 2 is picked up.

In this embodiment, the first shutter 7 is formed of a plate which is horizontally turned by an actuator 46 to close an opening 48 of a cylindrical casing 47, which faces the mounted surface F. The cylindrical casing 47 is located in front of the lens of the camera 4. The actuator 46, which may be a motor, is mounted on the cylindrical casing 47. A mark recognition path is opened and closed by turning the first shutter 7 formed of the plate. In this embodiment, the second shutter 9 is formed of an L-shaped plate which is vertically moved by an actuator 45, such as a solenoid or an air cylinder, which is mounted on the casing 47. The second shutter 9 formed of the L-shaped plate opens and closes an opening 49 of the casing 47, which faces the nozzle 2, to thereby open and close a part position recognition path. It is evident that the first and second shutters 7 and 9 are not limited to those plates as mentioned above, but may be optical shutters or mechanical shutters. The first and the second light source 8 and 10 may be EL elements or LEDs. The partial transmission mirror 6 is preferably a 50% transmission mirror, usually called a half mirror.

In this embodiment, the Z-shaft 1 includes a bearing member 14 and a shaft member 15. The bearing member 14, which is supported by a linear bearing 13 mounted on the apparatus stack, is movable vertically or in the axial direction (usually the up and down direction vertical to the mounted surface F). The shaft member 15, which is supported by the bearing member 14, is turned in a plane (usually a horizontal plane) parallel to the mounted surface F. A mounted part W absorbed and held by the tip is changed in its orientation through the turn of the shaft member 15, and is moved to and from the mounted surface F through the vertical movement of the bearing member 14.

In this embodiment, a frame 16, which rotatably supports a block 12 having the four absorption nozzles 2 arrayed in a cross, is coupled with the lower end of the Z-shaft 1. The nozzles 2 thus arrayed are turned in a plane (usually a horizontal plane) parallel to the mounted surface F. The block 12 with the absorption nozzles 2 attached thereto is supported by a bearing member 17, which is supported by the frame 16. The block 12 is disposed so that the center of rotation of it is parallel to the mounted surface F. Therefore, the absorption nozzles 2 are rotated in a plane vertical to the mounted surface F, to face the mounted surface F one by one in successive order. The block 12 is coupled with a shaft 19 above the frame 16 by a timing belt 18, and is turned together with the shaft 19.

The shaft 19 is coupled with a shaft 22 for index-rotation, through a pair of bevel gears 20 and 21. The shaft 22 extends passing through the shaft member 15 of the Z-shaft 1. A timing pulley 23 is firmly attached to the shaft 19. The timing belt 18 is put on the timing pulley 23 and a timing belt 24 of the block 12 in a stretched fashion. Reference numeral 25 designates a tension pulley for eliminating the slack of the timing belt 18. The rotation of the shaft 22 for index-rotation is transmitted through the paired bevel gears 20 and 21 to the shaft 19, and through the timing pulleys 23 and 24 to rotate the block 12. The timing belt 18, put on the pulleys 23 and 24, turns without any slippage on the pulleys 23 and 24. As a result, an exact index- rotation is secured. Though the whole frame 16 is turned when the shaft member 15 is turned, engagement of the paired bevel gears 20 and 21 is maintained during the rotation. To turn the shaft member 15, a timing belt 27 in mesh with a timing belt 26 mounted on the frame 16 is driven to turn by a drive source, for example, a motor 28.

A plural number of absorption nozzles 2 are radially mounted on the block 12 which is made index-rotation in a plane vertical to the mounted surface F, whereby forming absorption mounting means 11. When the block is turned, these nozzles successively pass the absorption position or the mounting position. In this embodiment, the four absorption nozzles 2 are radially and equidistantly arrayed on the block 12, thereby forming a cross. In the absorption mounting means 11, when the block 12 is turned every 90°, the absorption nozzles 2 are turned in the vertical plane. With the absorption nozzle 2 set downward, an electronic part W is picked up from a part supply means (not shown) by absorption, and is mounted on the printed circuit board P. In selecting the absorbing means, there is no particular restriction. However, a vacuum absorbing means is preferable since an adverse effect on the electronic part W is minimized. In this case, the vacuum absorbing means holds the electronic part W by vacuum attraction, and when it is moved to and positioned at a mounting location on the mounted surface F, it sets the part free for mounting it thereon by removing vacuum attraction. In this embodiment, four pressure sources are respectively connected to the four absorption nozzles 2, through four holes 37, 38, 39, and 40. These holes 37, 38, 39, and 40 are communicably connected to the pressure sources (not shown) through four paths 33 to 36, which are formed by partitioning and sealing a space between the bearing member 17 and the block 12 by sealing means, such as O-rings, and ports 29 to 32. The nozzles 2 and the ports 29 to 32 are respectively interconnected by means of pipes as the parts of the four holes 37 to 40 formed in the block 12, and blocks 41 to 44 connecting thereto. Paths as the parts of the holes 37 to 40 are formed in the blocks 41 to 44, respectively. Each pressure source is designed so as to be operable in either of two modes, a positive pressure generation mode and a negative pressure generation mode. To mount the electronic part W on the mounted surface, the mode of the pressure source is changed to the positive pressure generation mode at an absorption/mounting position, and to hold the electronic part W by absorptive attraction at other positions, it always operates the negative pressure generation mode. A solenoid valve, for example, is used for switching the positive pressure generation mode to the negative pressure generation mode and vice versa. To apply a podditive pressure, the absorption nozzle 2 connecting to the pressure generation source is opened to air.

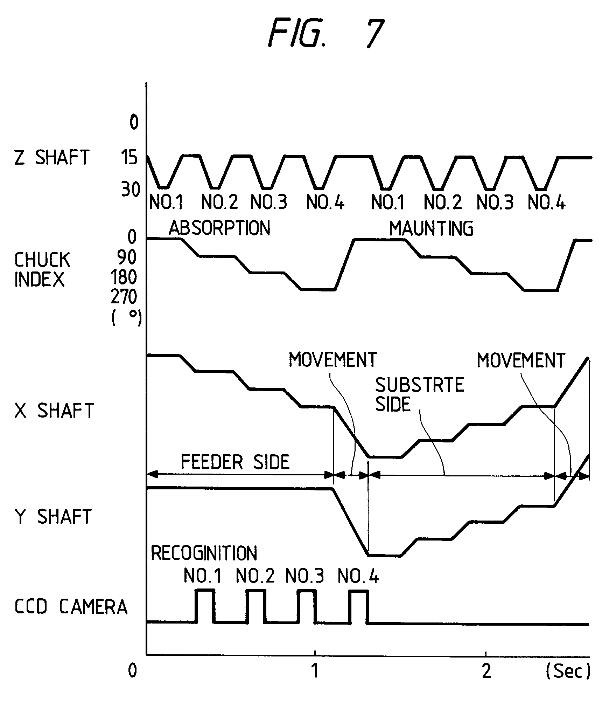

The electronic-part surface mounting apparatus thus constructed mounts an electronic part W on the mounted surface in accordance with a timing chart shown in Fig. 7.

The cross array of the absorption nozzles 2, which is mounted on the lower end of the Z-shaft 1, is turned at the step of 90°, and the nozzles 2 are successively directed downward. The nozzle 2 directed downward attracts an electronic part W from the part supply means, by absorption. The part attracting operation is successively performed with the turn of the nozzle array. During the part attracting operation, the second shutter 9 arrayed orthogonal to the mounted surface F is opened and the second light source 10 is switched on, while at the same time the first shutter 7 arrayed parallel to the mounted surface F is closed and the first light source 8 is switched off. Under this condition, the position of the electronic part W to be mounted is recognized by picking up an image on the nozzle, received through reflection by the partial transmission mirror 6. The process of the part position recognition is carried out in a manner that while one absorption nozzle 2 is indexed and the nozzle 2 picks up a new electronic part W, the position of the electronic part W previously picked up is recognized. In this way, during the part attracting operation, the positions of the picked up parts are recognized using the images reflected by the partial transmission mirror 6. To be more specific, in the nozzle array consisting of four nozzles 2, for example, the first nozzle attracts a first electronic part W by absorption and then the block 12 is turned by 90° in index-rotation, to direct the second nozzle 2 downward. When the second nozzle 2 attracts a second electronic part W, a process of recognizing the position of the first electronic part W seized by the first nozzle 2 starts. Then, the second nozzle 2 seizes the second electronic part W, and the nozzle array is further turned in index-rotation. Now, the third nozzle 2 starts its operation to seize a third electronic part W. During this part attrcting operation by the third nozzle 2, the position of the second electronic part W seized by the second nozzle 2 is recognized. In this way, the part attracting operation and the position recognition are concurrently performed. Thus, in a state that all the nozzles 2 hold the electronic parts W, the position of only one electronic part W is not yet recognized. The position recognition of this electronic part W will be completed till the mounter head 3 is moved to the mounting position, however.

Before the part mounting work, the position of the printed circuit board is recognized. To recognize the board position, the first shutter 7 arrayed parallel to the mounted surface F is opened, and the first light source 8 is switched on, while the second shutter 9 arrayed orthogonal to the mounted surface F is closed and the second light source 10 is switched off. An image on the mounted surface F, passed through the partial transmission mirror 6, is picked up. Thereafter, a given part mounting work is performed.

While having described the specific embodiment, it should be understood that the present invention may variously be modified, altered and changed within the scope of the invention. In the above-mentioned embodiment, the absorption nozzles are coupled with the vacuum absorption systems associated therewith, respectively. The absorbing/mounting system may be modified such that a positive pressure is applied to only the absorption nozzle directed downward only at the part mounting work.

As described above, in the electronic-part surface mounting apparatus of the present invention, an array of absorption nozzles, mounted on the lower end of the Z-shaft, is rotatable about an axis parallel to the mounted surface in a plane orthogonal to the mounted surface. A partial transmission mirror is located between the mounted surface and a camera. A first combination of a first shutter and a first light source is arrayed in a plane parallel to the mounted surface, which is provided for taking an image on the mounting surface, and a second combination of a second shutter and a second light source is arrayed in a plane orthogonal to the mounted surface, which is provided for taking an image on the absorption nozzle. In the first and second combinations, to take the image on the mounted surface, the first shutter is opened and the first light source is switched on, and to take the image on the absorption nozzle, the second shutter is opened and the second light source is switched on. Thus, the position recogition of the images can be made by one camera taking both the image on the absorption nozzle and the image on the mounted surface.

Further, the position recognition and the part mounting can successively be carried out by merely changing the first and second shutters and light sources and making index-rotation of the array of the absorption nozzles in a plane orthogonal to the mounted surface. Accordingly, the part mounting speed is increased by the time taken for the part to be moved to the camera. Furthermore, while an electronic part whose position recognition is first completed is moved on the mounted surface for its mounting, the position of the remaining electronic part can be recognized. Accordingly, the tact time of the mounting work is reduced.

## Claims

1. An electronic-part surface mounting apparatus, comprising:
a Z-shaft vertically movable with respect to a mounted surface of a printed circuit board on which an electronic part is to be mounted;
a camera with an optical axis parallel to said Z-shaft;
an array of absorption nozzles, mounted on a lower end of said Z-shaft, being rotatable about an axis parallel to said mounted surface in a plane orthogonal to said mounted surface;
a partial transmission mirror located between said mounted surface and said camera;
a first shutter and a first light source disposed in a first plane parallel to said mounted surface, a first image on said mounted surface being taken by said camera when said first shutter is opened and said first light source lights up said first image; and
a second shutter and a second light source disposed in a second plane orthogonal to said mounted surface, a second image on said absorption nozzle being taken by said camera when said second shutter is opened and said second light source lights up said second image.
